# EUROPEAN PATENT APPLICATION

(11) **EP 0 626 693 A2**
(43) Date of publication of application: **30.11.1994**
(21) Application number: 94302349.9
(22) Date of filing: 31.03.1994
(51) Int. Cl.: G11C 7/06, G11C 7/00, G11C 11/419

(54) **Multiplexing sense amplifier**

(30) Priority: 31.03.1993 US 40916; 31.03.1993 US 41321
(71) Applicant: SGS-THOMSON MICROELECTRONICS, INC., Carrollton Texas 75006 (US)
(72) Inventor: McClure, David Charles, Carrollton, Texas 75007 (US)
(74) Representative: Palmer, Roger

(57) **Abstract**

A memory system including a memory array having at least two pairs of data lines, first and second data lines, that correspond to columns in the memory array. A first stage is included having inputs connected to the two pairs of data lines. The first stage also has a pair of output lines, a true output line and a complement output line. A selection signal is used to selectively enable and disable the first and second data lines wherein one pair of data lines may be selected. An amplification circuit is connected to the first stage for amplifying the output signals from the first stage, and a logic circuit is used to generate logic output signals in response to the amplified output signals from the amplification circuit.

## Description

The present invention relates generally to the field of microelectronics and in particular to a method and apparatus for sensing signals from a memory array. Still more particularly, the present invention relates to a method and apparatus for selecting and sensing signals from a memory array.

Memories are devices that respond to operational orders, usually from a central processing unit (CPU) of a digital computer. A sense amplifier is typically employed to detect attenuated signals from a memory array. Two types of sense amplifiers are typically used: a static sense amplifier and a dynamic sense amplifier. Dynamic sense amplifiers are often used because they have low current consumption and the sense amplifiers are activated only when required to perform sensing functions.

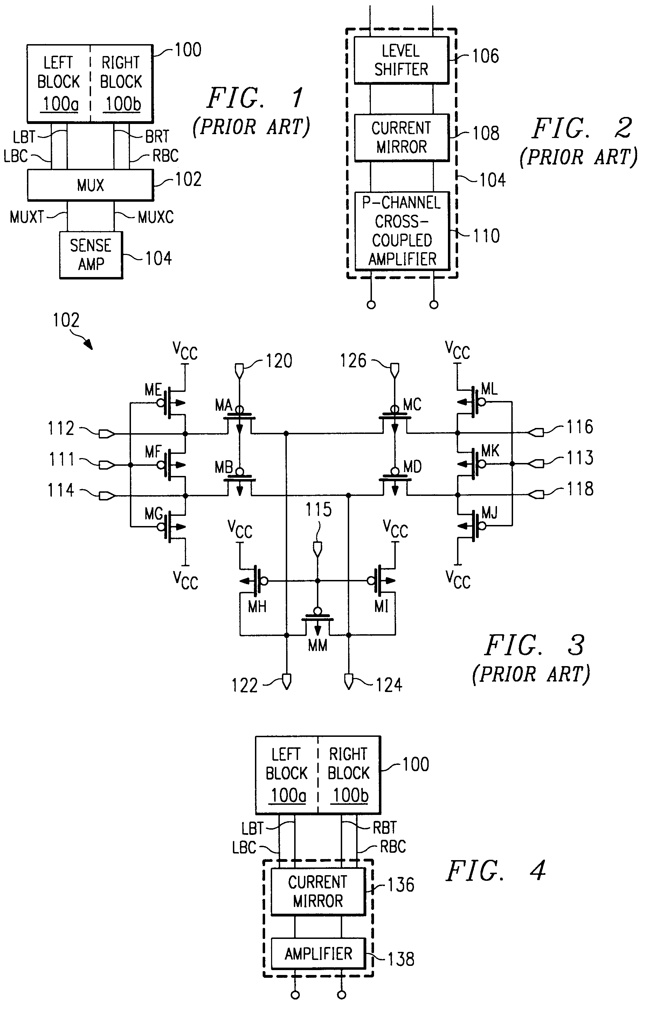

Referring to **Figure 1**, a memory array **100**, a multiplexer **102**, and a sense amplifier **104** are depicted in a configuration known to those skilled in the art. Memory array **100** contains a number of bit line pairs that may be accessed using word lines (not shown). Frequently in memory arrays, such as memory array **100**, sense amplifier **104** is shared among many columns of the memory array. In addition, the data fed into sense amplifier **104** might be multiplexed between different blocks of columns within memory array **100**. In the depicted example, left block **100a** and right block **100b** of memory array **100** share sense amplifier **104**. Two pairs of data lines, **LBT**, **LBC**, **RBT**, and **RBC** originate from memory array **100** and are connected to multiplexer **102**. Data lines **LBT** and **LBC** originate from left block **100a** of memory in memory array **100**; data lines **RBT** and **RBC** originate from right block **100b** in memory array **100**. Data lines **LBT** and **LBC** carry left block true and complement data signals respectively, while data lines **RBT** and **RBC** carry right block true and complement data signals respectively. Multiplexer **102** is used to select data from one pair of data lines and is connected to sense amplifier **104**. Sense amplifier **104** may include a number of different stages.

Referring next to **Figure 2**, sense amplifier **104** may include the following stages: level shifter **106**, current mirror **108**, and p-channel cross-coupled amplifier **110**. A level shifter is typically employed to shift the voltage of the multiplexed signals in order to optimize the other stages of the sense amplifier. Typically, level shifter **106** is used to adjust the voltage of the signal selected by multiplexer **102** in order to optimize the performance of the other stages within sense amplifier **104**. Sense amplifier **104** is employed to detect signals, in lines **MUXC** and **MUXT**, selected by multiplexer **102** from memory array **100**. Typically, sense amplifier **104** includes p-channel cross-coupled amplifier **110** with a high common-mode rejection in order to reject picked-up interference due to cross-talk from other parts of the system.

With reference now to **Figure 3**, a schematic diagram of a known multiplexer is illustrated. The multiplexer is constructed with transistors **MA-MM**. The transistors are p-channel metal-oxide semiconductor field effect transistors (MOSFETs). Multiplexer **102** is powered by connecting transistors **ME**, **MG**, **MH**, **MI**, **MJ**, and **ML** to power supply VCC. Points **111**, **113**, and **115** are points at which an equalization signal is applied to multiplexer **102**.

Data from data line **LBT** is fed into the multiplexer **102** at input point **112**; data from the data line **LBC** is fed into multiplexer **102** at input point **114**; data from data line **RBT** is fed into multiplexer **102** at input point **116**; and data from data line **RBC** is fed into multiplexer **102** at input point **118**.

The selection between the right block signals and the left block signals are made utilizing transistors **MA**, **MB**, **MC**, and **MD**. These transistors are p-channel MOSFETs. A low select signal into input point **120**, connected to the gates of transistors **MA** and **MB**, turns on transistors **MA** and **MB** causing the selection of signals from data lines **LBT** and **LBC** to be selected and sent out at output points **122** and **124**, as true complement signals in data lines **MUXT** and **MUXC** respectively. A low select signal into input point **126**, which is connected to the gates of transistors **MC** and **MD**, causes the true signal in data line **RBT** to be sent to sense amplifier **104** via output **122** connected to line **MUXT** and the complement signal from data line **RBC** to be sent to sense amplifier **104** via output point **124** connected to line **MUXC**. The use of multiplexer **102** typically causes a signal drop. It is desirable to have as much signal as possible for speed and reliability.

More information on semiconductor memories and sense amplifiers may be found in the following references: Prince, *Semiconductor Memories*, John Wiley and Sons (2nd Ed. 1991) and Haznedar, *Digital Microelectronics*, The Benjamin/Cummings Publishing company, Inc. (1991).

Therefore, it would be desirable to have a method and apparatus for multiplexing and sensing a data signal from a memory array without diminishing the data signal being sensed.

The present invention provides a memory system including a memory array having at least two pairs of data lines, first and second data lines corresponding to columns in the memory array. The memory array may also include two level shifter circuits, a first shifter circuit connected to the first lines and a second level shifter circuit connected to the second data lines, wherein the level shifter circuits produce output signals and may be enabled and disabled. A selection signal is used to selectively enable and disable the level shifter circuits, wherein one pair of data lines may be selected. An amplification circuit is connected to the level shifters for amplifying the output signals from the level shifter circuits, and a logic circuit is used to generate logic output signals in response to the amplified output signals from the amplification circuit.

The memory array may also include a selection stage having inputs connected to the two pairs of data lines. The selection stage also has a pair of output lines, a true output line and a complement output line, wherein output signals generated in the output lines are controlled by a first and second set of transistors. Each transistor in the first set has a gate connected to one of the input lines, and each transistor in the second set is connected in series with one of the transistors in the first set and may be selectively turned on and turned off, wherein one of the two pairs of data lines may be selected by turning transistors on and off in the second set.

The present invention may also include a multiplexing sense amplifier circuit for use with a memory array, which includes a level shifter stage having two level shifter circuits, a first level shifter circuit connected to a first input line and a first complement input line and a second level shifter circuit connected to a second input line and a second complement input line. Each level shifter circuit has two outputs, a true output and a complement output, and a select input. The level shifter circuits are responsive to a select signal, for enabling or disabling the level shifter circuit. The first level shifter circuit is disabled when the second level shifter circuit is enabled, and the first level shifter circuit is enabled when the second level shifter circuit is disabled, providing selection of signals from one of the two level shifter circuits.

The present invention may also include a multiplexing sense amplifier circuit for use with a memory array, which includes a selection stage having inputs connected to first and second data lines. This selection stage also has a pair of output lines, a true output line and a complement output line, wherein output signals generated in the output lines are controlled by a first and second set of transistors. Each transistor in the first set has a gate connected to one of the input lines, and each transistor in the second set is connected in series with one of the transistors in the first set and may be selectively turned on and turned off, wherein one of the two data lines may be selected by turning transistors on and off in the second set.

The multiplexing sense amplifier circuit may also have a second stage having a true output and a complement output, the second stage being connected to the true and complement outputs of the level shifter stage, wherein the true output and the complement output of the second stage is controlled by the outputs of the level shifter. An amplifier stage or logic circuit may be connected to the true output and the complement output of the second stage. The amplifier has a pair of outputs, wherein the amplifier generates logic 1 and logic 0 signals at the pair of outputs in the amplifier stage in response to signals from the true output and complement output of the second stage. Alternatively, the output of the second stage may be used without the amplifier or logic circuit.

The second stage of the multiplexing sense amplifier may include a pair of current mirrors. Other circuits that may be used in the second stage of the multiplexing sense amplifier include, for example, a p-channel cross-coupled amplifier, a differential amplifier, or a level shifter.

According to a preferred embodiment of the present invention there is provided a memory system comprising a memory array having at least two pairs of data lines, first and second data lines corresponding to columns in the memory array, at least two level shifter circuits, a first shifter circuit connected to the first lines and a second level shifter circuit connected to the second data lines, wherein the level shifter circuits produce output signals and may be enabled and disabled, a selection signal for selectively enabling and disabling the level shifter circuits, wherein one pair of data lines may be selected, and an amplification circuit connected to the level shifters for amplifying the output signals from the level shifter circuits.

Preferably the memory system further comprises a logic circuit for generating logic output signals in response to the amplified output signals from the amplication circuit.

The logic circuit may comprise a flip-flop circuit or a p-channel cross-coupled metal-oxide semiconductor field effect amplifier.

Preferably each data line is a data line pair.

The amplification circuit may comprise two current mirrors.

The amplification circuit may comprise a p-channel cross-coupled amplifier.

The amplification circuit may comprise a differential amplifier.

The amplification circuit may comprise a level shifter.

According to a second preferred embodiment of the present invention there is provided a multiplexing sense amplifier circuit for use with a memory array comprising a level shifter stage having at least two level shifter circuits, a first level shifter circuit connected to a first input line and a first complement input line and a second level shifter circuit connected to a second input line and a second complement input line, each level shifter circuit having two outputs, a true output and a complement output, and a select input, responsive to a select signal, for enabling or disabling the level shifter circuit, wherein the first level shifter circuit is disabled when the second level shifter circuit is enabled and the first level shifter circuit is enabled when the second level shifter circuit is disabled and wherein selection of signals from one of the two level shifter circuits may be accomplished, and a second stage having a true output and a complement output, the second stage being connected to the true and complement outputs of the level shifter stage, wherein the true output and the complement output of the second stage are controlled by the outputs of the level shifter stage.

Preferably the multiplexing sense amplifier circuit further comprises an amplifier stage connected to the true output and the complement output of the second stage, the amplifier having a pair of outputs, wherein the amplifier generates logic 1 and logic 0 signals at the pair of outputs in the amplifier stage in response to signals from the true output and complement output of the second stage.

Preferably the multiplexing sense amplifier comprises a first pair of transistors and a second pair of transistors, each pair of transistors having a first transistor connected in parallel with a second transistor in the pair, the gate of the first transistor in the first pair being connected to the true output of the first level shifter circuit, the gate of the second transistor in the first pair being connected to the true output of the second level shifter circuit, the gate of the first transistor in the second pair being connected to the complement output of the first level shifter circuit, and the gate of the second transistor in the second pair being connected to the complement output of the second level shifter circuit, wherein the two pairs of transistors control the true output and the complement output of the second stage.

The amplifier stage may be a p-channel cross-coupled amplifier comprising two p-channel metal-oxide field effect transistors, each p-channel metal-oxide transistor having a gate connected to a drain of the other p-channel metal-oxide field effect transistor, and two n-channel metal-oxide field effect transistors, each n-channel metal-oxide field effect transistor having a drain connected to the drain of a p-channel metal-oxide field effect transistor, wherein the true output of the second stage is connected to the gate of the first n-channel metal-oxide field effect transistor and the complement output of the second stage is connected to the gate of the second n-channel metal-oxide field effect transistor.

The second stage may comprise a pair of current mirrors, a first current mirror and a second current mirror, the first current mirror having an output controlled by the outputs of the first and second level shifter circuits and the second current mirror having an output controlled by the outputs of the first and second level shifter circuits.

Preferably each current mirror includes four control transistors for controlling the current output of the current mirror.

Preferably the first control transistor has its gate connected to the true output of the first level shifter circuit, the second control transistor is connected in parallel with the first control transistor and has its gate connected to the true output of the second level shifter circuit, the third control transistor has a gate connected to the complement output of the first level shifter circuit, and the fourth control transistor is connected in parallel with the third control transistor and has a gate connected to the complement output of the second level shifter circuit.

The second stage may comprise a cross-coupled amplifier having two pairs of control transistors for controlling the output of the second stage and wherein the two pairs are controlled by the outputs from the two level shifter circuits.

Preferably each control transistor in the first pair is connected in parallel with one of the control transistor in the second pair and wherein the first pair is controlled by the outputs of the first level shifter circuit and the second pair is controlled by the outputs of the second level shifter circuit.

The second stage may comprise a differential amplifier having two pairs of transistors controlling the output of the second stage and wherein the two pairs are controlled by the outputs from the two level shifter circuits.

The second stage may comprise a level shifter circuit having two pairs of transistors controlling the output of the second stage.

Preferably each transistor in the first pair is connected in parallel with one of the transistors in the second pair and wherein the first pair is controlled by the outputs of the first level shifter circuit and the second pair is controlled by the outputs of the second level shifter circuit.

According to a third preferred embodiment of the present invention there is provided a multiplexing sense amplifier circuit for use with a memory array comprising a first stage having at least two circuits, a first circuit connected to a first input line and a first complement input line and a second circuit connected to a second input line and a second complement input line, each circuit having two outputs, a true output and a complement output, and a select input, responsive to a select signal, for enabling or disabling the circuit, wherein the first circuit is disabled when the second circuit is enabled and the first circuit is enabled when the second circuit is disabled and wherein selection of signals from one of the two circuits may be accomplished, and a second stage having a true output and a complement output, the second stage being connected to the true and complement outputs of the first stage, wherein the true output and the complement output of the second stage are controlled by the outputs of the first stage.

Preferably the multiplexing sense amplifier circuit further comprises an amplifier stage connected to the true output and the complement output of the second stage, the amplifier having a pair of outputs, wherein the amplifier generates logic 1 and logic 0 signals at the pair of outputs in the amplifier stage in response to signals from the true output and complement output of the second stage.
The second stage may comprise a first pair of transistors and a second pair of transistors, each pair of transistors having a first transistor connected in parallel with a second transistor in the pair, the gate of the first transistor in the first pair being connected to the true output of the first circuit, the gate of the second transistor in the first pair being connected to the true output of the second circuit, the gate of the first transistor in the second pair being connected to the complement output of the first circuit, and the gate of the second transistor in the second pair being connected to the complement output of the second circuit, wherein the two pairs of transistors control the true output and the complement output of the second stage.

Preferably the amplifier stage is a p-channel cross-coupled amplifier comprising two p-channel metal-oxide field effect transistors, each p-channel metal-oxide transistor having a gate connected to a drain of the other p-channel metal-oxide field effect transistor, and two n-channel metal-oxide field effect transistors, each n-channel metal-oxide field effect transistor having a drain connected to the drain of a p-channel metal-oxide field effect transistor, wherein the true output of the second stage is connected to the gate of the first n-channel metal-oxide field effect transistor and the complement output of the second stage is connected to the gate of the second n-channel metal-oxide field effect transistor.

The second stage may comprise a pair of current mirrors, a first current mirror and a second current mirror, the first current mirror having an output controlled by the outputs of the first and second circuits and the second current mirror having an output controlled by the outputs of the first and second circuits.

Preferably each current mirror includes four control transistors for controlling the current output of the current mirror.

Preferably the first control transistor has its gate connected to the true output of the first circuit, the second control transistor is connected in parallel with the first control transistor and has its gate connected to the true output of the second circuit, the third control transistor has a gate connected to the complement output of the first circuit, and the fourth control transistor is connected in parallel with the third control transistor and has a gate connected to the complement output of the second circuit.

The second stage may comprise a cross-coupled amplifier having two pairs of control transistors for controlling the output of the second stage and wherein the two pairs are controlled by the outputs from the two circuits.

Preferably each control transistor in the first pair is connected in parallel with one of the control transistors in the second pair and wherein the first pair is controlled by the outputs of the first circuit and the second pair is controlled by the outputs of the second circuit.

Preferably the cross-coupled amplifier is a p-channel cross-coupled amplifier.

The second stage may comprise a differential amplifier having two pairs of transistors controlling the output of the second stage and wherein the two pairs are controlled by the outputs from the two circuits.

The second stage may comprise a level shifter circuit having two pairs of transistors controlling the output of the second stage.

Preferably each transistor in the first pair is connected in parallel with one of the transistors in the second pair and wherein the first pair is controlled by the outputs of the first circuit and the second pair is controlled by the outputs of the second circuit.

Preferably a level shifter circuit in the level shifter stage is disabled by disconnecting a power supply connection to VCC from the level shifter circuit.

Preferably both outputs of a level shifter circuit are forced low in response to disablement of the level shifter circuit.

According to a fourth preferred embodiment of the present invention there is provided a memory system comprising a memory array having at least two pairs of data lines, first and second data lines, corresponding to columns in the memory array, and a selection stage having inputs connected to the two pairs of data lines, the selection stage also having a pair of output lines, a true output line and a complement output line, wherein output signals generated in the output lines are controlled by a first and second set of transistors, each transistor in the first set has a gate connected to one of the input lines and each transistor in the second set is connected in series with one of the transistors in the first set and may be selectively turned on and turned off, wherein one of the two pairs of data lines may be selected by turning transistors on and off in the second set.

According to a fifth preferred embodiment of the present invention there is provided a a multiplexing sense amplifier circuit comprising a selection stage having inputs connected to first and second data lines, the selection stage also having a pair of output lines, a true output line and a complement output line, wherein output signals generated in the output lines are controlled by a first and second set of transistors, each transistor in the first set has a gate connected to one of the input lines and each transistor in the second set is connected in series with one of the transistors in the first set and may be selectively turned on and turned off, wherein one of the two data lines may be selected by turning transistors on and off in the second set.

Selection of signals from the first data lines may be accomplished by turning off the transistors in the second set of transistors that are connected in series with transistors having gates connected to the second data lines.

The selection stage preferably comprises one of: two current mirrors, a p-channel cross-coupled amplifier, a differential amplifier, a level shifter circuit, one current mirror.

The novel features believed characteristic of the invention are set forth in the appended claims. The invention itself however, as well as a preferred mode of use, and further objects and advantages thereof, will best be understood by reference to the following detailed description of an illustrative embodiment when read in conjunction with the accompanying drawings, wherein:
Figure 1 is a block diagram of a portion of a memory system illustrating a configuration of a memory array, a multiplexer, and a sense amplifier known in the prior art;
Figure 2 is a block diagram of a sense amplifier known in the prior art;
Figure 3 is a schematic diagram of a multiplexer known in the prior art;
Figure 4 is a block diagram of a portion of a memory system configured according to the present invention;
Figure 5 is a schematic diagram of a current mirror according to the present invention;
Figure 6 is a schematic diagram of a p-channel cross-coupled amplifier according to the present invention;
Figure 7 is a schematic diagram of a p-channel cross-coupled amplifier according to the present invention;
Figure 8 is a schematic diagram of a differential amplifier according to the present invention;
Figure 9 is a schematic diagram of a level shifter according to the present invention;
Figure 10 is a block diagram of a portion of a memory system configured according to the present invention;
Figure 11 is a schematic diagram of a cross-coupled level shifter according to the present invention;
Figure 12 is a schematic diagram of a pair of current mirrors and a p-channel cross-coupled amplifier according to the present invention;
Figure 13 is a schematic diagram of a p-channel cross-coupled amplifier according to the present invention;
Figure 14 is a schematic diagram of a differential amplifier according to the present invention; and
Figure 15 is a schematic diagram of a level shifter according to the present invention.

In accordance with a preferred embodiment of the present invention, the multiplexing function is incorporated into the sense amplifier in order to reduce the effects of having a separate multiplexer selecting signals as illustrated in the prior art design in Figure 1.

Referring now to **Figure 4**, a block diagram of a portion of a memory system configured according to the present invention is illustrated. Memory array **100** again includes left block **100a** and right block **100b**. Signals from data lines **LBT**, **LBC**, **RBC**, and **RBT** are fed directly into sense amplifier **130**, instead of a multiplexer. Signals from data lines **LBT** and **RBT** are true signals, while signals from data lines **LBC** and **RBC** are complement signals. In accordance with a preferred embodiment of the present invention, sense amplifier **130** includes a current mirror stage **136** and an amplifier stage **138**. Multiplexing or selection functions are incorporated into current mirror stage **136** in accordance with a preferred embodiment of the present invention.

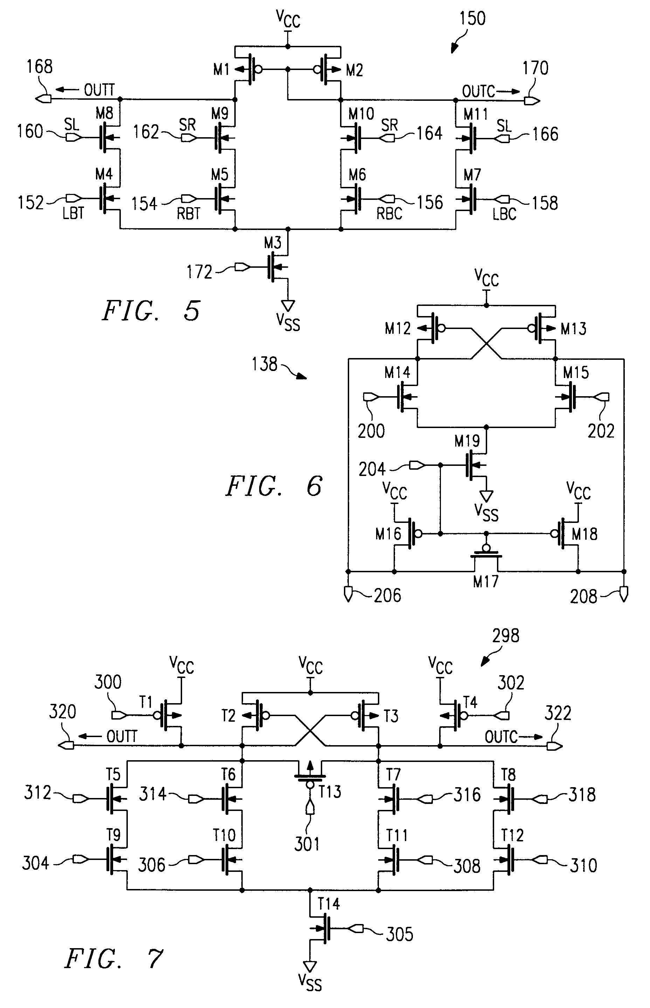

Next, **Figure 5** illustrates a schematic diagram of a current mirror in accordance with a preferred embodiment of the present invention. Current mirror **150** is comprised of transistors **M1-M11** and forms a portion of the selection stage of the sense amplifier. These transistors are n-channel and p-channel MOSFETs. The circuit is powered by connecting the drains of transistors **M1** and **M2** to power supply VCC, while connecting the source of transistor **M3** to power supply VSS. Power supply VCC is typically at a higher voltage relative to power supply VSS. This circuit is enabled and disabled via signal applied to, the gate of transistor **M3** through input point **172**. The circuit is disabled when transistor **M3** is turned off.

In this circuit, data line LBT is connected to transistor **M4** at input point **152** in **Figure 4**; data line RBT is connected to the gate of transistor **M5** at input point **154** in **Figure 4**; data line RBC is connected to the gate of transistor **M6** at input point **156** in **Figure 4**; and data line LBC is connected to the gate of transistor **M7** at input point **158**. Transistors **M4-M7** control the flow of current mirror **150**. The current flow varies in response to signals applied to the gates of these transistors from the data lines.

A pair of data lines, **LBT** and **LBC** or **RBT** and **RBC**, may be selected in this circuit, depicted in **Figure 4**, using transistors **M8-M11**, which are in a series configuration with transistors **M4-M7**. The series connections are as follows: transistor **M8** is in series with transistor **M4**; transistor **M9** is in series with transistor **M5**; transistor **M10** is in series with transistor **M6**; and transistor **M11** is in series with transistor **M7**. Selection signals at input points **160**, **162**, **164**, and **166** control the output at output points **168** and **170**. If the left block signals **LBT** and **LBC** are to be selected, a high signal is applied to the gates of transistors **M8** and **M11**, via input points **160** and **166**. A low signal is applied to the gates of transistors **M9** and **M10**, via input points **162** and **164**. As a result, current flows through transistors **M4**, **M7**, **M8**, and **M11** since transistors **M8** and **M11** allow current to flow. The low signal applied to the gates of transistors **M9** and **M10** prevents current flow through that portion of the circuit. A "high signal" is a signal that completely turns on a transistor, while a "low signal" is a signal that completely turns off a transistor.

Similarly, if a selection of data lines **RBT** and RBC are desired, a high signal is applied to the gates of transistors **M9** and **M10**, via input points **162** and **164** while a low signal is applied to the gates of transistors **M8** and **M11** via input points **160** and **166**.

In accordance with a preferred embodiment of the present invention, two current mirror circuits, such as current mirror **150** are utilized in current mirror stage **136**. The first current mirror circuit supplies signal **OUTT** through output point 168, while the other current mirror circuit supplies signal **OUTC** through its output point **168**, and has its inputs reversed from those shown in Figure 5.

Referring now to **Figure 6**, a schematic diagram of a amplifier stage **138** within a sense amplifier is depicted according to the present invention. Amplifier stage **138** is constructed from transistors **M12-M19**. This circuit is powered by connecting the sources of transistors **M12** and **M13** to power supply VCC and connecting the source of transistor **M19** to power supply VSS. This amplifier stage is a p-channel cross-coupled amplifier and functions as a flip-flop in accordance with a preferred embodiment of the present invention. Transistors **M12** and **M13** are p-channel transistors, while transistor **M14-M19** are n-channel transistors.

Output point **168** in **Figure 5** is connected to input point **200**, and output point **170** in **Figure 5** is connected to input point **202**. Transistors **M14** and **M15** control the output of amplifier circuit **198**. The output is determined by the **OUTT** and **OUTC** from signals from the mirror circuits as applied to the gates of transistors **M14** and **M15**, respectively. Transistors **M12-M15** form a flip-flop in this circuit. Transistor **M17** provides balancing within the circuit, and transistors **M16** and **M18** are used to precharge the circuit. The circuit is enabled and disabled by applying a control signal to input point **204** to the gates of transistors **M16**, **M17**, **M18**, and **M19**. The circuit is disabled when **M19** is turned off.

Output points **206** and **208** provide logic outputs in response to signals **OUTT** and **OUTC** being applied to the gates of transistors **M14** and **M15** via input points **200** and **202**. Signals **OUTT** and **OUTC** from the current mirror stage are processed in this circuit to produce a logic "1" or logic "0" output at output points **206** and **208**.

Current mirror stage **136** in **Figure 4** may be replaced by a number of different stages in accordance with a preferred embodiment of the present invention. For example, a p-channel cross-coupled amplifier **298**, as depicted in **Figure 7**, may be used in place of the two current mirrors in current mirror stage **136** in **Figure 4**. P-channel cross-coupled amplifier **298** is constructed from transistors **T1-T14**. Transistors **T1-T4** are p-channel MOSFETs. The remaining transistors, **T5-T14**, are n-channel MOSFETs. P-channel cross-coupled amplifier **298** is powered by connecting transistors **T1-T4** to power supply VCC and connecting the source of transistor **T14** to power supply VSS. P-channel cross-coupled amplifier **298** is enabled when a select signal is high at input points **300**, **301**, and **302**, and **305**, which are connected to the gates of transistors **T1**, **T4**, and **T14**.

In this circuit, input point **304** is connected to data line **LBT**, input point **306** is connected to data line **RBT**, input point **308** is connected to data line **RBC**, and input point **310** is connected to data line **LBC**. Signals from these data lines control the gates transistors **T9-T12** which results in a varying amount of current flowing through the transistors in response to varying signals from the data lines. These transistors are connected in a serious configuration with transistor **T5-T8** as follows: transistor **T5** is connected in series with transistor **T9**; transistor **T6** is connected in series with transistor **T10**; transistor **T7** is connected in series with transistor **T11**; and transistor **T8** is connected in series with transistor **T12**.

Transistors **T5-T8** work in conjunction with transistors **T9-T12** to provide a output resulting from a selection of two data lines from the memory array. Select signals are applied to input points **312**, **314**, **316** and **318** to select signals from the left block of data lines, **LBT** and **LBC**, or the right block of data lines, **RBT** and **RBC**. The resulting output signal **OUTT** is applied to the gate of transistor **M14** in the amplifier **in Figure 6** by connecting output point **320** to input point **200**, while the resulting output signal **OUTC** is applied to the gate of transistor **M15** in **Figure 6** by connecting output point **322** to input point **202**.

Right block signals, **RBT** and **RBC** are selected by applying a high signal to the gates of transistors **T6** and **T7** via input points **314** and **316**, while applying a low signal to transistors **T5** and **T8** through input points **312** and **318**.

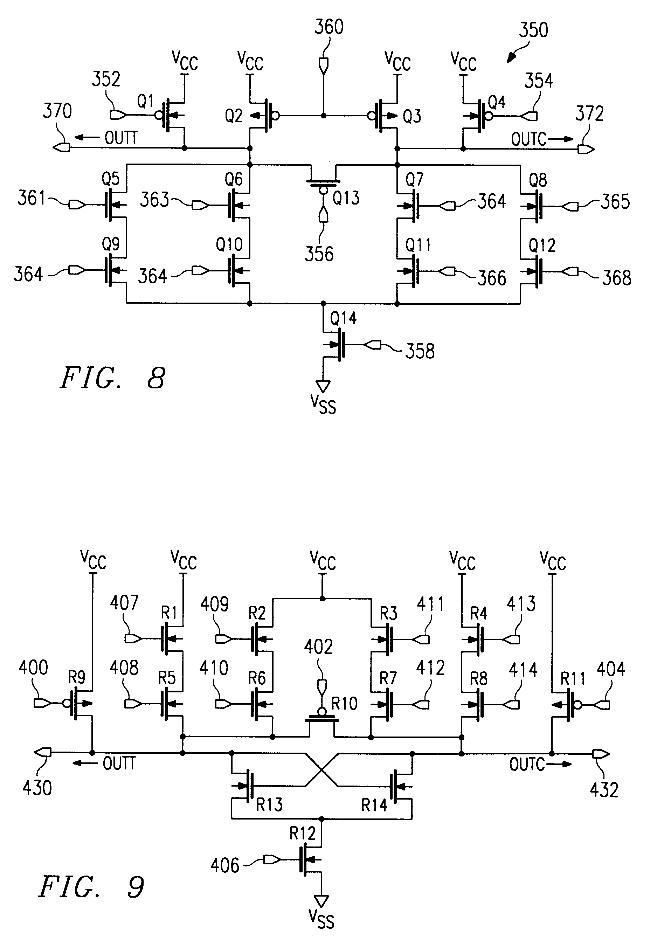

Referring now to **Figure 8**, a schematic diagram of a differential amplifier, which may be substituted in place of current mirror stage **136** in **Figure 4** is illustrated. Differential amplifier **350** is comprised of transistors **Q1-Q14**. Transistors **Q1**, **Q2**, **Q3**, **Q4**, and **Q13** are p-channel MOSFETs, while the remaining transistors are n-channel MOSFETs. This circuit is powered by connected the sources of transistors **Q1-Q4** to power supply VCC and connecting the source of transistor **Q14** to power supply VSS.

Transistors **Q1**, **Q4**, and **Q13** are used to enable and disable differential amplifier **350**. These transistors are controlled by control signals at input points **352**, **354**, **356**, and **358**. A bias signal (or ground) is applied to the amplifier at input point **360**, which controls the gates of transistors **Q2** and **Q3**. The gate of transistor **Q9** is connected to data line **LBT** at input point **364** and the gate of transistor **Q10** is connected to data line **RBT** at input point **364**. The gate of transistor **Q11** is connected to data line **RBC** at input point **366** while the gate of transistor **Q12** is connected to data line **LBC** at input point **368**.

Transistors **Q5-Q8** are used to select the data lines for amplification. These transistors are placed in series with transistors **Q9-Q12** in the following manner: transistor **Q5** is connected in series with transistor **Q9**; transistor **Q6** is connected in series with transistor **Q10**; transistor **Q7** is connected in series with **Q11**; and transistor **Q8** is connected in series with transistor **Q12**. Select signals at input points **361**, **363**, **364**, and **365** are used to control the transistors **Q5-Q8** to select data lines for amplification.

For example, if the right block data lines, **RBT** and **RBC**, are desired, a high signal is applied to the gates of transistors **Q6** and **Q7** via input points **363** and **364**. In addition, a low signal is applied to the gates of transistors **Q5** and **Q8** through input points **361** and **365**. As a result of these signals, no current flows through transistors **Q5**, **Q9**, **Q8** and **Q12**, while current flows through transistors **Q6**, **Q10**, **Q7**, and **Q11**. The current flow through transistors **Q6**, **Q10**, **Q7**, and **Q11** is determined by the voltage to the gates of transistors **Q10** and **Q11**. Signal **OUTT** controls the gate of transistor **M14** in **Figure 6** through a connection between output point **370** and input point **200**. Signal **OUTC** controls transistor **M15** in **Figure 6** through a connection between output point **372** and input point **202**.

Referring now to **Figure 9**, transistors **R1-R12** form a level shifter that may be used in place of the current mirrors in current mirror stage **138** in **Figure 4**. Transistors **R9**, **R10**, and **R11** are p-channel MOSFETs, while transistors **R1-R8** and **R12** are n-channel MOSFETs in accordance with a preferred embodiment of the present invention. Transistors **R9-R12** are employed to enable and disable the circuit through signals at input points **400**, **402**, **404**, and **406** connected to the gates of these transistors. The circuit is powered by connecting the drains of transistors **R1-R4**, **R9**, and **R11** to power supply VCC while connecting the source of transistor **R12** to power supply VSS.

The gate of transistor **R1** is connected to data line **LBT**, and the gate of transistor **R2** is connected to data line **RBT**. The gate of transistor **R3** is connected to data line **RBC**, while the gate of transistor **R4** is connected to data line **LBC**. These transistors, **R1-R4**,are connected in a series configuration with transistors **R5-R8** as follows: **R1** in series with **R5**, **R2** in series with **R6**, **R3** in series with **R7**, and **R4** in series with **R8**. Transistors **R5-R8** are used to select signals from selected data lines. These transistors, **R5-R8**, are controlled by signals applied to input points **408**, **410**, **412**, and **414**.

For example, if signals from the left block of data lines **LBT** and **LBC** are desired, a high signal would be applied to the gates of transistors **R5** and **R8**, while a low signal would be applied to the gates of transistors **R8** and **R7**. As a result, current would flow through transistors **R1**, **R5**, **R4**, and **R8** and not through transistors **R2**, **R6**, **R3** and **R7**. Signals from data lines **RBT** and **RBC** would be selected by applying a high signal to transistors **R6** and **R7** and a low signal to transistors **R5** and **R8**. The output signal generated, **OUTT** controls the gate of transistor **M14** in **Figure 6** by connecting output point **430** with input point **200**. The output signal **OUTC** controls the gate of transistor **M15** through a connection between output point **432** and input point **202** in **Figure 6**.

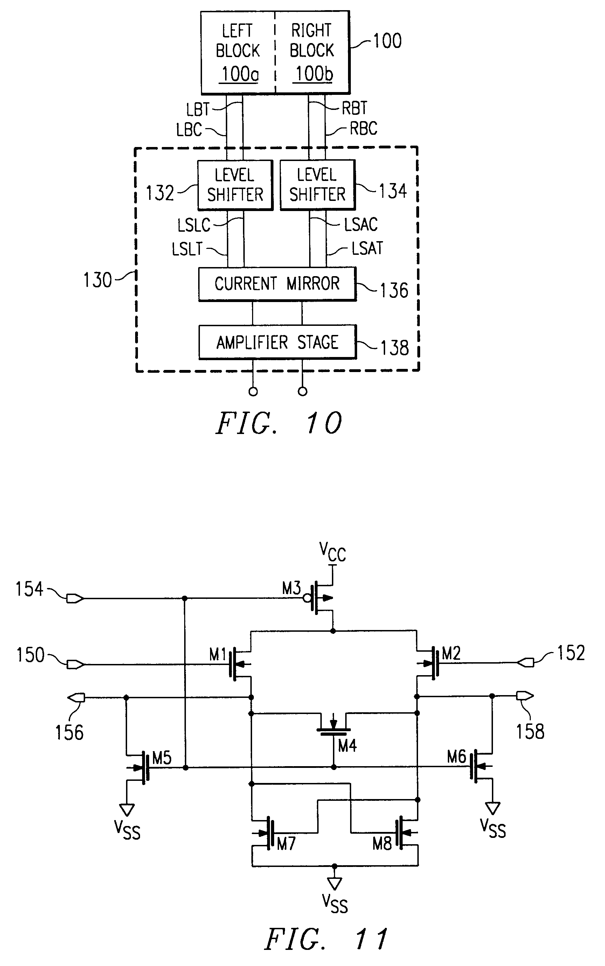

Referring now to **Figure** 10, a block diagram of a portion of a memory system configured according to the present invention is illustrated. Memory array **100** again includes left block **100a** and right block **100b**. Signals from data lines **LBT**, **LBC**, **RBC**, and **RBT** are fed directly into sense amplifier **130** instead of a multiplexer. Signals from data lines **LBT** and **RBT** are true signals, while signals from data lines **LBC** and **RBC** are complement signals. In accordance with a further preferred embodiment of the present invention, sense amplifier 130 includes level shifter **132**, level shifter **134**, current mirror stage **136**, and amplifier stage **138**. Multiplexing functions are incorporated into level shifters **132** and **134** in accordance with a further preferred embodiment of the present invention.

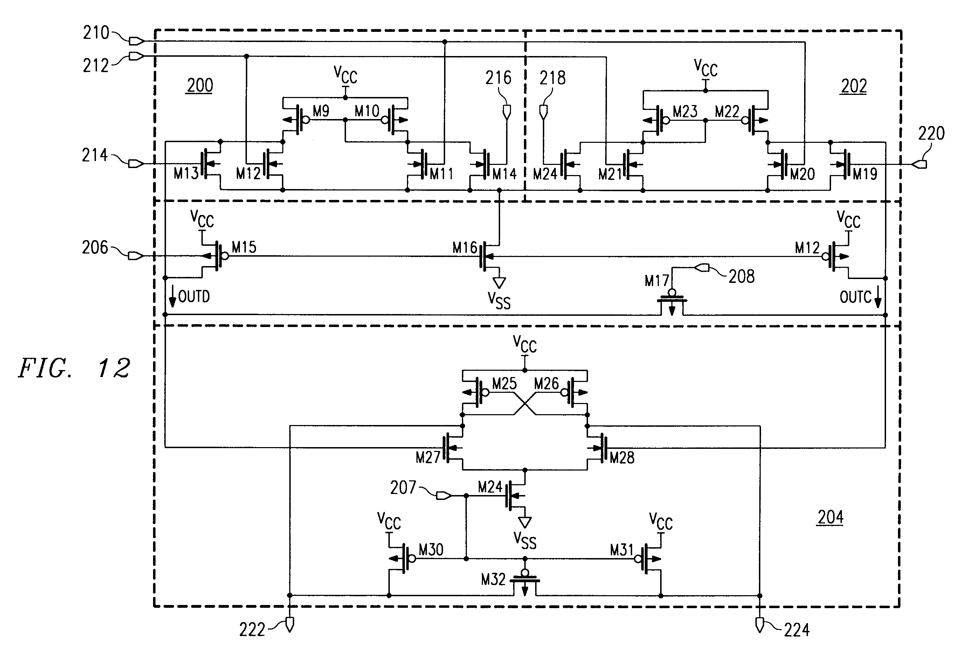

Referring now to **Figure** 11, a schematic diagram of a cross-coupled level shifter according to the present invention is depicted. Transistors **M1-M8** comprise the cross-coupled level shifter. These transistors are n-channel and p-channel MOSFETs. Transistors **M1**, **M2**, **M4-M8** are n-channel MOSFETs, and transistor **M3** is a p-channel MOSFET in accordance with the further preferred embodiment of the present invention.Input points **150** and **152** receive either signals from data lines **LBT** and **LBC**, or signals from data lines **RBT** and **RBC**, respectively. These signals control the gates of transistors **M1** and **M2** respectively. Transistors **M7** and **M8** are shown in a cross-coupled connection. Other configurations may be used, such as, tying the drain of each transistor, **M7** and **M8**, to the transistor's own gate or by tying the gates to a bias voltage. The drain of transistor **M3** is connected to power supply VCC, and the sources of transistors **M5-M8** are connected to power supply VSS. These connections provide power to operate the circuit. Power supply VCC is at a higher voltage relative to power supply VSS.

The level shifter incorporates a multiplexing function in accordance with a preferred embodiment of the present invention. This multiplexing function is controlled by a select signal at input point **154** in level shifters **132** and **134**. The select signal controls the gate of transistor **M3**. If the gate of transistor **M3** is turned on, the level shifter allows the passage of the true and complement signals through output points **156** and **158** respectively. A high signal at input point **154** disables the level shifter, forcing the output at output points **156** and **158** to be low. On the other hand, when the signal at input point **154** is low, the level shifter performs normally in accordance with a preferred embodiment of the present invention.

By selecting only one of the two level shifters, **132** or **134**, as depicted in **Figure** 10 a 2 to 1 multiplexing of the signals from the memory array is achieved without diminishing signal strength in accordance with a preferred embodiment of the present invention. The output from output point **156** is a signal **LSLT** in level shifter **132** and a signal **LSRT**, right block true signal, in level shifter **134**; the output from output point **158** is a signal **LSLC**, left block complement signal, in level shifter **132** and a signal **LSRC**, right block complement signal, in level shifter **134**. In accordance with a further preferred embodiment of the present invention, more than two level shifters may be used depending on the design of the memory system.

Next, **Figure** 12 illustrates a schematic diagram of a pair of current mirrors and a p-channel cross-coupled amplifier within a sense amplifier in accordance with a further preferred embodiment of the present invention. Current mirror stage **136** includes current mirrors **200** and **202**. Current mirror **200** is constructed from transistors **M9-M14**; current mirror **202** is constructed from transistors **M19-M24**. Transistors **M9**, **M10**, **M22**, and **M23** are p-channel MOSFETs while the rest of the transistors in the two current mirrors are n-channel MOSFETs in accordance with the preferred embodiment of the present invention. P-channel cross-coupled amplifier **204** is constructed from transistors **M25-M32**. Transistors **M25**, **M26**, **M30**, **M31**, and **M32**, are p-channel transistors, while transistors **M27**, **M28**, and **M29** are n-channel transistors in p-channel cross-coupled amplifier **204**. Transistors **M25-M28** form a flip-flop in this circuit. Transistor **M32** is employed to provide balancing within the circuit, and transistors **M30** and **M31** are utilized to pre-charge the circuit.

Transistors **M15-M18** are employed to enable, disable, and pre-charge the sense amplifier in accordance with a further preferred embodiment of the present invention. The current mirrors and the amplifier are powered by connecting the drains of transistors **M9**, **M10**, **M15**, **M18**, **M22**, **M23**, **M25**, **M26**, **M30**, and **M31** to power supply VCC, while the sources of transistors **M16**, and **M29** are connected to power supply VSS. Power supply VCC is typically at a higher voltage than power supply VSS.

Signals at input points **206**, **207**, and **208** enable and disable the circuits. Input points **210** and **212** carry signals LSRC and LSRT from level shifter **134** while input points **214** and **218** carry signal LSLC from level shifter **132**. Input points **216** and **220** carry signal LSRT from level shifter **132**. Signal LSRC controls the gates of transistors **M11** and **M20**; signal LSRT controls the gates of transistors **M12** and **M21**. Transistors **M13** and **M24** are controlled by signal LSLT; transistors **M14** and **M19** are controlled by signal LSLC.

In accordance with a further preferred embodiment of the present invention, current mirrors **200** and **202** are current mirrors with additional transistors added in parallel to control the output of the current mirrors. Transistors **M12** and **M13** are connected in parallel; transistors **M11** and **M14** are in parallel; transistors **M21** and **M24** are connected in parallel; and transistors **M20** and **M19** are connected in parallel. These transistors control the current flow in the current mirrors.

If level shifter **134** is not selected and level shifter **132** has been selected, the signals at input points **210** and **212** are low. A low signal is a signal that turns the transistor off. As a result, transistors **M11**, **M12**, **M20**, and **M21** are turned off. The signals at input points **214**, **216**, **218** and **220** correspond to the output from level shifter **132**, resulting in various levels of current flowing through transistors **M13**, **M14**, **M24**, and **M19** depending on the voltage at the gates of transistors by signals supplied by lines **LSLT** and **LSLC**. The output signals, **OUTT** and **OUTC**, from these two current mirrors control the gates of transistors **M27** and **M28** in p-channel cross-coupled amplifier **204** resulting in output signals **DATAT** and **DATAC** at output points **222** and **224** respectively. Signal **DATAC** is the complement of signal **DATAT**.

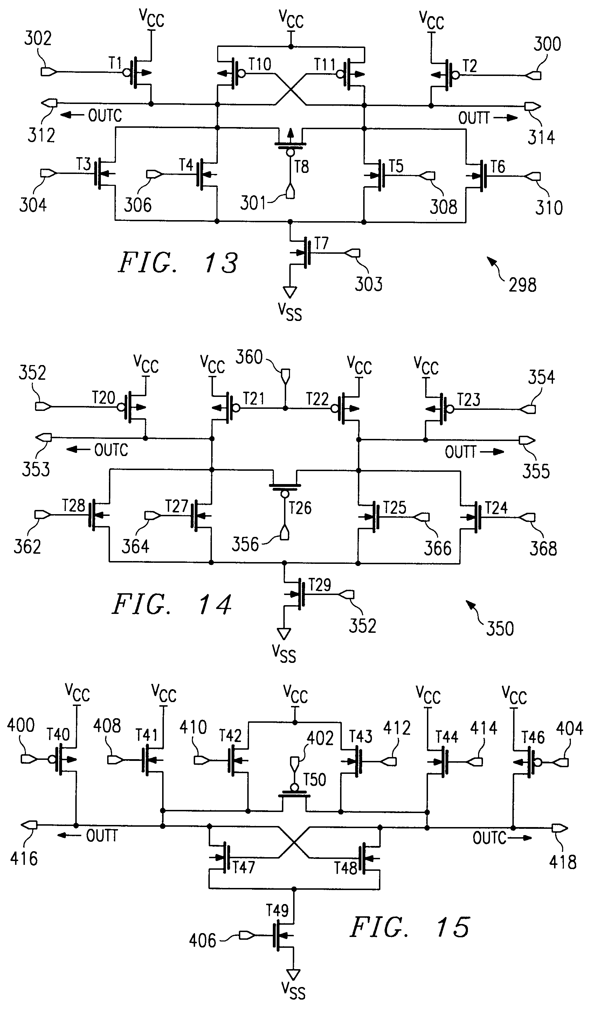

Current mirror stage **136** in **Figure** 10 may be replaced by a number of different stages in accordance with a further preferred embodiment of the present invention. For example, a p-channel cross-coupled amplifier **298**, as depicted in **Figure** 13, may be utilized in place of the two current mirrors **200** and **202** illustrated in **Figure** 12. P-channel cross-coupled amplifier **298** is constructed from transistors **T1-T11**. Transistors **T1**, **T2**, **T8**, **T10**, and **T11** are p-channel MOSFETs. The remaining transistors are n-channel MOSFETs. P-channel cross-coupled amplifier **298** is powered by connecting transistors **T1**, **T2**, **T10**, and **T11** to power supply VCC and connecting the drain of transistor **T7** to power supply VSS.

P-channel cross-coupled amplifier **298** is enabled when a select signal is high at input points **300**, **301**, **302**, and **303**. These signals control the gates of transistors **T1**, **T2**, **T7**, and **T8**. Input points **304** and **306** are connected to the gates of transistors **T3** and **T4** respectively; input points **308** and **310** are connected to the gates of transistors **T5** and **T6** respectively. Again, a parallel configuration of transistor **T3** in parallel with transistor **T4** and transistor **T5** in parallel with transistor **T6** is employed in accordance with a preferred embodiment of the present invention. Signal LSLT enters input point **304**; signal LSRT enters input point **306**; signal LSRC enters input point **308**; and signal LSLC enters input point **310**. If level shifter **134** is disabled and level shifter **132** is selected, signals LSRT and LSRC will be low, causing transistors **T4** and **T5** to be turned off. Signals LSLT and LSLC will correspond to the output from level shifter **132**, allowing various amounts of current to flow through transistors **T3** and **T6** in response to different voltages being applied to the gates of these two transistors in accordance with a further preferred embodiment of the present invention.

Transistors **T10** and **T11** are the cross-coupled p-channel MOSFETs within the amplifier. Signal OUTC travels from output point **312** to transistor **M28** in amplifier **204** in **Figure 6**. Signal OUTT travels from output point **314** to transistor **M27** in amplifier **204** in **Figure** 12. The depicted embodiment in **Figure** 12 illustrates employing an amplifier connected to the current mirrors to produce a logic signal. According to the present invention, some other logic circuit may be used in place of amplifier **204**. Furthermore, the circuit below current mirrors **200** and **202** may be eliminated, and the output from current mirrors **200** and **202** may be directly used as the output of the sense amplifier.

Referring now to **Figure** 14, a schematic diagram of a differential amplifier, which may be substituted in place of current mirrors **200** and **202** in **Figure** 12, is illustrated in accordance with a further preferred embodiment of the present invention. Differential amplifier **350** is comprised of transistors **T20-T29**. Transistors **T20-T23** and **T26** are p-channel MOSFETs while the remaining transistors are n-channel MOSFETs. This circuit is powered by connecting the drains of transistors **T20**, **T21**, **T22**, and **T23** to power supply VCC and connecting the source of transistor **T29** to power supply VSS.

Transistors **T20**, **T23**, **T26** and **T29** enable and disable differential amplifier **350**. These transistors are controlled by control signals at input points **352**, **354**, **356**, and **358**. A bias signal (or ground) is applied to the amplifier at input point **360**, which controls the gates of transistors **T21** and **T22**. Transistor **T28** is controlled by signal LSLT at input point **362**. Transistor **T27** is controlled by signal LSRT at input point **364**. Transistor **T25** is controlled by signal LSRC at input point **366**. Transistor **T24** is controlled by signal LSLC at input point **368**. Output point **353** is connected to the gate of transistor **M28** in amplifier **204** and provides a complement output signal **OUTC**, while output point **355** is connected to the gate of transistor **M27** in amplifier **204** and provides an output signal, **OUTT**.

Referring now to **Figure** 15, transistors **T40-T50** are utilized to form a level shifter that may be utilized in place of current mirrors **200** and **202** in **Figure 6**. Transistors **T40**, **T46**, and **T50** are p-channel MOSFETs, while transistors **T41**, **T42**, **T43**, **T44**, **T47**, **T48**, and **T49** are n-channel MOSFETs in accordance with a further preferred embodiment of the present invention. Transistors **T40**, **T46**, **T49**, and **T50** are employed to enable and disable the circuit. Control signals at input points **400**, **402**, **404**, and **406** control the gates of these transistors. The circuit is powered by connecting the drains of transistors **T40**, **T41**, **T44**, and **T46** to power supply VCC, while connecting the source of transistor **T49** to power supply VSS.

Transistor **T41** is controlled by signal LSLT applied to input point **408**. Transistor **T42** is controlled by signal LSRT applied to input point **410**; transistor **T43** is controlled by signal LSRC applied to input point **412**; and transistor **T44** is controlled by signal LSLC applied to input point **414**. Transistors **T41** and **T42** are in parallel; transistors **T43** and **T44** are in parallel. Output point **416** is connected to the gate of transistor **M27** in amplifier **204** in **Figure** 12. Output point **418** is connected to the gate of transistor **M28** in amplifier **204** is **Figure** 12. The output signals at output points **416** and **418** are determined by the input signals at input points **408**, **410**, **412**, and **414**. For example, if level shifter **134** is disabled and level shifter **132** is selected, transistors **T41** and **T44** would be turned on, while transistors **T42** and **T43** would be turned off. The output at output point **416** would depend on signal LSLT at input point **408**, which controls transistor **T41**. The output at output point **418** would depend on signal LSLC at input point **414**, controlling transistor **T44**.

The present invention allows for selection of signals by enabling and disabling a pair of level shifters, instead of using a separate multiplexer. Transistors controlling the output in later Stages are placed in parallel and controlled by the output signals from the level shifters. Although, two level shifters are depicted, other numbers of level shifters may be utilized in different memory array configurations. Although the depicted embodiment illustrates the selection of signals by enabling and disabling a pair of level shifters, other circuits other than level shifters may be manipulated in a similar function within a sense amplifier to provide selection of signals.

In addition, the depicted embodiments illustrate an implementation involving pairs of data lines, carrying true and complement signals. Those of ordinary skill in the art will appreciate that a single data line implementation, instead of a pair of data lines, may be employed according to the present invention. A differential amplifier may be used to produce a true and complement signal from a single data line.

In addition, the depicted embodiments illustrate the use of an amplifier stage in addition to a selection stage such as a current mirror, p-channel cross-coupled amplifier, a differential amplifier, and a level shifter. In accordance with a preferred embodiment of the present invention, this second stage may be eliminated depending on the design considerations. As a result, signals from the selection stage are provided as the outputs of the sense amplifier.

One advantage of the present invention is that it provides a faster and more sensitive sense amplifier because signal losses resulting from signals propagating through a transmission gate in a multiplexer stage are eliminated. Additionally, the present invention provides for smaller and simpler circuitry for selecting and sensing signals from data lines in multiple blocks of memory. The present invention is depicted using MOS technology. Other types of technology and transistors may be utilized in accordance with a preferred embodiment of the present invention.

While the invention has been particularly shown and described with reference to preferred embodiments, it will be understood by those skilled in the art that various changes in form and detail may be made therein without departing from the spirit and scope of the invention.

## Claims

1. A memory system comprising:
a memory array having at least two pairs of data lines, first and second data lines corresponding to columns in the memory array;
at least two level shifter circuits, a first shifter circuit connected to the first lines and a second level shifter circuit connected to the second data lines, wherein the level shifter circuits produce output signals and may be enabled and disabled;
a selection signal for selectively enabling and disabling the level shifter circuits, wherein one pair of data lines may be selected; and
an amplification circuit connected to the level shifters for amplifying the output signals from the level shifter circuits.

2. The memory system of claim 1 further comprising:
a logic circuit for generating logic output signals in response to the amplified output signals from the amplication circuit.

3. The memory system of claim 2, wherein the logic circuit comprises one of a flip-flop circuit or a p-channel cross-coupled metal-oxide semiconductor field effect amplifier.

4. A multiplexing sense amplifier circuit for use with a memory array comprising:
a level shifter stage having at least two level shifter circuits, a first level shifter circuit connected to a first input line and a first complement input line and a second level shifter circuit connected to a second input line and a second complement input line, each level shifter circuit having two outputs, a true output and a complement output, and a select input, responsive to a select signal, for enabling or disabling the level shifter circuit, wherein the first level shifter circuit is disabled when the second level shifter circuit is enabled and the first level shifter circuit is enabled when the second level shifter circuit is disabled and wherein selection of signals from one of the two level shifter circuits may be accomplished; and
a second stage having a true output and a complement output, the second stage being connected to the true and complement outputs of the level shifter stage, wherein the true output and the complement output of the second stage are controlled by the outputs of the level shifter stage.

5. The multiplexing sense amplifier circuit of claim 4 further comprising:
an amplifier stage connected to the true output and the complement output of the second stage, the amplifier having a pair of outputs, wherein the amplifier generates logic 1 and logic 0 signals at the pair of outputs in the amplifier stage in response to signals from the true output and complement output of the second stage.

6. The multiplexing sense amplifier of claim 5, wherein said second stage comprises a first pair of transistors and a second pair of transistors, each pair of transistors having a first transistor connected in parallel with a second transistor in the pair, the gate of the first transistor in the first pair being connected to the true output of the first level shifter circuit, the gate of the second transistor in the first pair being connected to the true output of the second level shifter circuit, the gate of the first transistor in the second pair being connected to the complement output of the first level shifter circuit, and the gate of the second transistor in the second pair being connected to the complement output of the second level shifter circuit, wherein the two pairs of transistors control the true output and the complement output of the second stage.

7. A multiplexing sense amplifier circuit for use with a memory array comprising:
a first stage having at least two circuits, a first circuit connected to a first input line and a first complement input line and a second circuit connected to a second input line and a second complement input line, each circuit having two outputs, a true output and a complement output, and a select input, responsive to a select signal, for enabling or disabling the circuit, wherein the first circuit is disabled when the second circuit is enabled and the first circuit is enabled when the second circuit is disabled and wherein selection of signals from one of the two circuits may be accomplished; and
a second stage having a true output and a complement output, the second stage being connected to the true and complement outputs of the first stage, wherein the true output and the complement output of the second stage are controlled by the outputs of the first stage.

8. The multiplexing sense amplifier circuit of claim 7 further comprising:
an amplifier stage connected to the true output and the complement output of the second stage, the amplifier having a pair of outputs, wherein the amplifier generates logic 1 and logic 0 signals at the pair of outputs in the amplifier stage in response to signals from the true output and complement output of the second stage.

9. The multiplexing sense amplifier of claim 8, wherein said second stage comprises a first pair of transistors and a second pair of transistors, each pair of transistors having a first transistor connected in parallel with a second transistor in the pair, the gate of the first transistor in the first pair being connected to the true output of the first circuit, the gate of the second transistor in the first pair being connected to the true output of the second circuit, the gate of the first transistor in the second pair being connected to the complement output of the first circuit, and the gate of the second transistor in the second pair being connected to the complement output of the second circuit, wherein the two pairs of transistors control the true output and the complement output of the second stage.

10. The multiplexing sense amplifier of claim 8 or claim 5, wherein the amplifier stage is a p-channel cross-coupled amplifier comprising two p-channel metal-oxide field effect transistors, each p-channel metal-oxide transistor having a gate connected to a drain of the other p-channel metal-oxide field effect transistor, and two n-channel metal-oxide field effect transistors, each n-channel metal-oxide field effect transistor having a drain connected to the drain of a p-channel metal-oxide field effect transistor, wherein the true output of the second stage is connected to the gate of the first n-channel metal-oxide field effect transistor and the complement output of the second stage is connected to the gate of the second n-channel metal-oxide field effect transistor.

11. A memory system comprising:
a memory array having at least two pairs of data lines, first and second data lines, corresponding to columns in the memory array; and
a selection stage having inputs connected to the two pairs of data lines, the selection stage also having a pair of output lines, a true output line and a complement output line, wherein output signals generated in the output lines are controlled by a first and second set of transistors, each transistor in the first set has a gate connected to one of the input lines and each transistor in the second set is connected in series with one of the transistors in the first set and may be selectively turned on and turned off, wherein one of the two pairs of data lines may be selected by turning transistors on and off in the second set.

12. A multiplexing sense amplifier circuit comprising:
a selection stage having inputs connected to first and second data lines, the selection stage also having a pair of output lines, a true output line and a complement output line, wherein output signals generated in the output lines are controlled by a first and second set of transistors, each transistor in the first set has a gate connected to one of the input lines and each transistor in the second set is connected in series with one of the transistors in the first set and may be selectively turned on and turned off, wherein one of the two data lines may be selected by turning transistors on and off in the second set.

13. The multiplexing sense amplifier of claim 11 or claim 12 further comprising a logic circuit for generating logic output signals in response to the output signals from the selection stage.

14. The multiplexing sense amplifier of claim 13, wherein the logic circuit comprises a flip-flop or a p-channel cross-coupled metal-oxide semiconductor field effect transistor amplifier.
